# EUROPEAN PATENT APPLICATION

(11) **EP 1 648 033 A2**
(43) Date of publication of application: **19.04.2006**
(21) Application number: 05022340.3
(22) Date of filing: 13.10.2005
(51) Int. Cl.: H01L 27/32, H01L 51/56

(54) **Organic Electro-Luminescence display device and method of fabricating the same**

(30) Priority: 14.10.2004 KR 2004082234; 14.10.2004 KR 2004082235; 14.10.2004 KR 2004082236; 14.10.2004 KR 2004082237
(71) Applicant: LG Electronics Inc., Yongdungpo-gu Seoul (KR)
(72) Inventor: Bae, Hyo, Dae, Daegu (KR)
(74) Representative: Zech, Stefan Markus

(57) **Abstract**

The present invention relates to an organic electro-luminescence display device and a method of fabricating the same capable of improving an emission efficiency and of reducing a deterioration of picture quality.

An organic electro-luminescence display device, including a display area and a non-display area, according to the present invention includes: a data line and a scan line, which are formed in a direction crossing each other, at the display area; a data link, extended from the data line, and a scan link, connected to the scan line, at the non-display area; and a data pad extended with a width wider than that of the data link and connected to the end of the data link formed at the non-display area, and a scan pad extended with a width wider than that of the scan link and connected to the end of the scan link formed at the non-display area, wherein at least any one of the data link, the data pad, the scan link, and the scan pad are formed in a multi conductive layer.

## Description

This application claims the benefit of Korean Patent Application Nos. P2004-82234, P2004-82235, P2004-82236, and P2004-82237 filed in Korea on October 14, 2004, which are hereby incorporated by reference.

### BACKGROUND OF THE INVENTION

### FIELD OF THE INVENTION

The present invention relates to an organic electro-luminescence display device, and more particularly, to an organic electro-luminescence display device and a method of fabricating the same capable of improving an emission efficiency and reducing a deterioration of picture quality.

### DESCRIPTION OF THE RELATED ART

Recently, there have been developed various flat panel display devices reduced in weight and bulk that is capable of eliminating disadvantages of a cathode ray tube (CRT). Such flat panel display devices include a liquid crystal display (LCD), a field emission display (FED), a plasma display panel (PDP) and an electro-luminescence (EL) display, etc.

In such flat panel display devices, the PDP has the most advantage for making a large dimension screen because its structure and manufacturing process are simple, but has a drawback in that it has low light-emission efficiency and large power consumption. The LCD has a difficulty in making a large dimension screen because it is fabricated by a semiconductor process, but has an expanded demand as it is mainly used for a display device of a notebook personal computer. However, the LCD has a drawback in that it has a difficulty in making a large dimension screen and it has large power consumption due to a backlight unit. Also, the LCD has characteristics of a large light loss and a narrow viewing angle due to optical devices such as a polarizing filter, a prism sheet, a diffuser and the like.

On the other hand, the EL display device is largely classified into an inorganic EL device and an organic EL device depending upon a material of a light-emitting layer, and is a self-luminous device. When compared with the above-mentioned display devices, the EL display device has advantages of a fast response speed, large light-emission efficiency, a large brightness and a large viewing angle. The organic EL display device can display a picture at approximately 10[V] and a high brightness of ten thousands of [cd/m²].

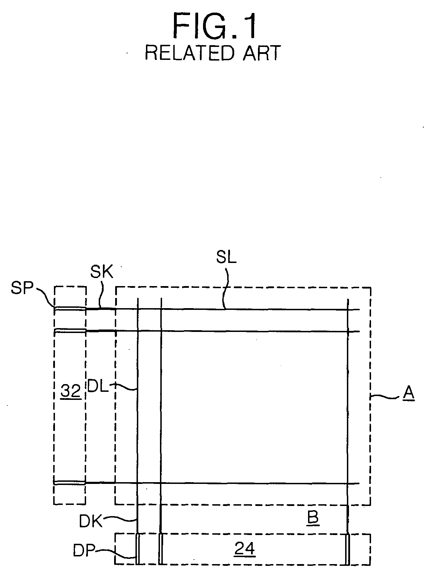

FIG. 1 is a schematic plan view illustrating a structure of a related art organic EL display device.

Referring to FIG. 1, the related art organic EL display device includes: a data line DL and a scan line SL crossing each other; and a display area A, where an EL cell(not shown) formed at a cross of the data line DL and the scan line SL in a matrix type is located, and where a picture is realized upon organic emission.

The related art organic EL display device further includes: a data link DK extended from the data line DL of the display area A; a data pad part 24 provided with a data pad DP, having a width wider than that of the data link DK at the end part of the data link DK; a scan link SK connected to the scan line SL; and a non-display area B where a scan pad part 32 is located, wherein the scan pad part 32 has a scan pad SP having a width wider than that of the scan link SK at the end part of the scan link SK.

The data pad part 24 and the scan pad part 32 are connected to a tape carrier package TCP (not shown) on which a data driver (not shown) generating a data signal and a scan driver (not shown) generating a scan signal are mounted.

The data pad part 24 supplies the data signal, applied from the data driver to the data line DL, via each data pad DP and data link DK, to the corresponding data line DL. The scan pad part 32 supplies the scan signal, applied from the scan driver to the scan line SL, via each scan pad SP and scan link SK, to the corresponding scan line SL.

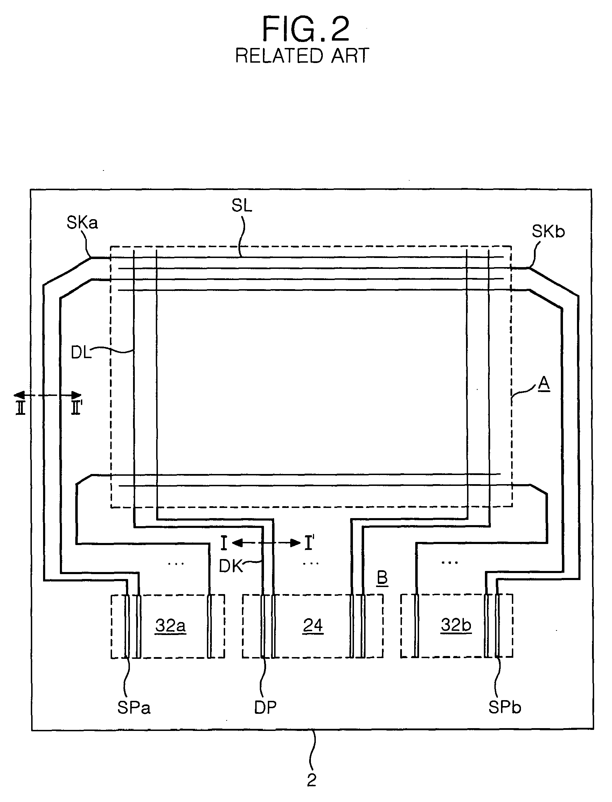

FIG. 2 is a schematic plan view illustrating another related art organic EL display device.

To compare to the organic EL display device in FIG. 1, the organic EL display device in FIG. 2 includes: a data pad part 24, a first scan pad part 32a and a second scan pad part 32b, wherein the first scan pad part 32a and the second scan pad part 32b are separated from each other in both sides for the purpose of integration of the display device and are formed at a lower side of a substrate 2 of the organic EL display device together.

A reason of forming the data pad part 24, the first scan pad part 32a and the second scan pad part 32b together on the lower side of the substrate of the organic EL display device is for making the display area A of the organic EL display device to be located at a center of the display device in a case that the drivers are integrated to produce the display device.

Referring to FIG. 2, each data link DK extended from the data line DL of the display area A is connected, via the non-display area B, to the data pad DP corresponded to the data pad part 24 formed at the lower side of the substrate 2. Each of scan links SKa and SKb is connected, via the non-display area B, to each of scan pads SPa and SPb corresponded to the scan pad parts 32a and 32b formed at the lower side of the substrate 2.

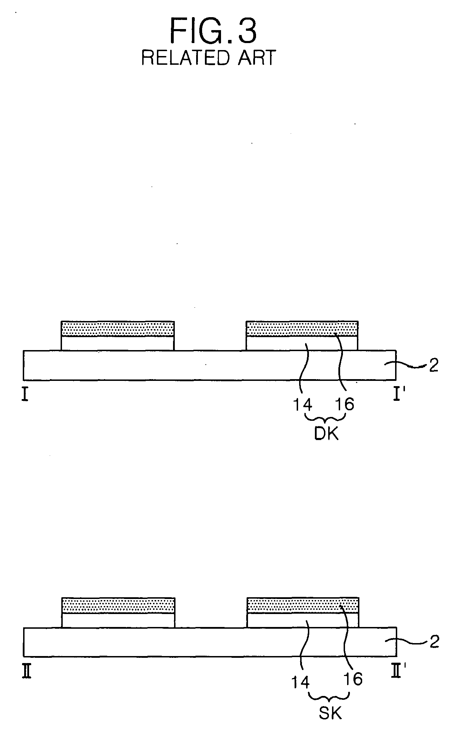

FIG. 3 is sectional view illustrating the data link DK and the scan link SK taken along lines I-I' and II-II' in FIG. 2.

Referring to FIG. 3, the data link DK and the scan link SK formed at the non-display area B of the organic EL display device include a transparent conductive layer 14 and a metal layer formed on the transparent conductive layer 14.

Each transparent conductive layer 14 of the data link DK and the scan link SK formed at the non-display area B is formed by the same process as the data line formed at the display area A. After a conductive material such as chrome Cr or molybdenum Mo is entirely deposited on the substrate and is patterned to form the metal layer 16 of the data link DK and the scan link SK so as to cover the transparent conductive layer 14 of the data link DK and the scan link SK.

Since the transparent conductive layer 14 is formed of indium-tin-oxide (ITO), indium-zinc-oxide (IZO), and indium-tin-zinc-oxide (ITZO), etc., which have a high resistance, the data link DK and the scan link SK have a high resistance. The high resistance of the data link DK and the scan link SK by such the transparent conductive layer 14 reduces an emission efficiency of the display device and distorts the signal applied to the data line DL and the scan line SK via each data link DK and scan link SK from the data pad DP and the scan pads SPa and SPb. It makes a reason deteriorating a picture quality upon driving the EL cell.

By the above reason, the metal layer 16 is formed on the transparent conductive layer 14 of the data link DK and the scan link SK by use of chrome Cr or molybdenum Mo in order to compensate the high resistance of the related art data link DK and the scan link SK. However, chrome Cr used for forming the metal layer 16 to compensate the high resistance of the data link DK and the scan link SK has a resistance of 12.7**Ω**cm. In a case of molybdenum Mo, since a resistance of the molybdenum Mo is higher than the chrome Cr, the compensation of the resistance by the transparent conductive layer 14 of the data link DK and the scan link SK is insufficient.

Furthermore, a use of aluminum Al having a resistance lower than that of the chrome Cr or molybdenum Mo has been suggested. However, when the aluminum Al is contacted with oxygen, the aluminum Al has a characteristic be oxidized. Due to the characteristic of the aluminum Al, there is a problem that aluminum Al having a low resistance cannot be used for forming the metal layer 16 of the data link DK and the scan link SK in the organic EL display device.

In addition, as shown in FIG. 2, in a case of the scan link SK contrary to the data link DK, each scan link SK passes through the non-display area B of a long distance in order to be connected to the corresponding scan pads Spa and SPb. Accordingly, the scan link SK passing through the non-display area B of the long distance has a resistance lager than that of the data link DK. The large resistance of the scan link SK is a fact more deteriorating emission efficiency and a picture quality.

### SUMMARY OF THE INVENTION

Accordingly, it is an object of the present invention to provide an organic electro-luminescence display device and a method of fabricating the same capable of improving an emission efficiency and reducing a deterioration of picture quality.

In order to achieve these and other objects of the invention, an organic electro-luminescence display device, including a display area and a non-display area, according to a embodiment of the present invention includes a data line and a scan line, which are formed in a direction crossing each other, at the display area; a data link, extended from the data line, and a scan link, connected to the scan line, at the non-display area; and a data pad extended with a width wider than that of the data link and connected to the end of the data link formed at the non-display area, and a scan pad extended with a width wider than that of the scan link and connected to the end of the scan link formed at the non-display area, wherein at least any one of the data link, the data pad, the scan link, and the scan pad are formed in a multi conductive layer.

The data link, the data pad, the scan link, and the scan pad are formed in a multi conductive layer having a transparent conductive layer.

The multi conductive layer includes the transparent conductive layer formed on a substrate; an aluminum layer formed on the transparent conductive layer; a first metal layer formed between the transparent conductive layer and the aluminum layer; and a second metal layer formed on the aluminum layer.

The first metal layer prevents corrosion caused when the aluminum layer is connected to the transparent conductive layer.

The second metal layer prevents corrosion caused when the aluminum is exposed in the air.

Each of the first and the second metal layers includes at least any one of chrome and molybdenum.

The data link and the data pad are formed in only a single conductive layer, and the scan link and the scan pad are formed in a multi conductive layer.

The single conductive layer is a transparent conductive layer.

The multi conductive layer includes aluminum.

The multi conductive layer includes: an aluminum layer on a substrate; and a metal layer, covering the aluminum layer, on the aluminum layer.

The metal layer prevents the aluminum layer from being contacted with oxygen.

The metal layer includes at least any one of chrome and molybdenum.

Each of the data link, the data pad, the scan link, and the scan pad includes an aluminum layer and a metal layer stacked on the aluminum layer, and the data link includes a transparent conductive layer stacked on the metal layer.

The metal layer prevents the aluminum layer from being contacted with oxygen.

The metal layer includes at least any one of chrome and molybdenum.

An organic electro-luminescence display device, according to a embodiment of the present invention including a display area and a non-display area, comprising a data line formed of a transparent conductive layer at the display area; a scan line crossing the data line with an organic light-emitting layer therebetween, at the display area; a data link formed of an aluminum layer at the non-display area to separate from the data line in a longitudinal direction of the data line and a data pad extended with a width wider than that of the data link and connected to the end of a longitudinal direction of the data link; a scan link formed of an aluminum layer at the non-display area to connect to the scan line and a scan pad extended with a width wider than that of the scan link and connected to the end of a longitudinal direction of the scan link; and a sub data link formed of a metal layer at the non-display area to cover the data link and the data pad and to electrically connect the data line with the data link.

The organic electro-luminescence display device further comprising a sub scan link formed of the metal layer at the non-display area to cover the scan link and the scan pad.

The scan link, the scan pad, the data link and the data pad are formed same materials.

The sub scan link and the sub data link are formed same materials.

The metal layer includes at least any one of chrome and molybdenum.

The sub data link and the sub scan link prevent the data link, the data pad, the scan link, and the scan pad from being contacted with oxygen.

A method of fabricating an organic electro-luminescence display device, according to a embodiment of the present invention including a display area and a non-display area, comprising forming a data line at the display area, and a transparent conductive layer of: a data link extended from the data line; a data pad extended with a width wider than that of the data link and connected to the end of a longitudinal direction of the data link at the non-display area; a scan link; and a scan pad extended with a width wider than that of the scan link and connected to the end of a longitudinal direction of the scan link formed at the non-display area; forming a multi conductive layer on the transparent conductive layer of the data link, the data pad, the scan link, and the scan pad; and forming a scan line, connected to the scan link and crossed with the data line, at the display area.

The forming the multi conductive layer includes forming a first metal layer on the transparent conductive pattern; forming an aluminum layer on the first metal layer; and forming a second metal layer on the aluminum layer.

The first metal layer prevents corrosion caused when the aluminum layer is contacted with the transparent conductive layer.

The second metal layer prevents corrosion caused when the aluminum layer is exposed in the air.

The first and the second metal layer include at least any one of chrome and molybdenum.

A method of fabricating an organic electro-luminescence display device, according to a embodiment of the present invention including a display area and a non-display area, comprising forming a data line at the display area, and a data link, connected to the data line, having a single conductive layer, and a data pad connected to the end of the data link, at the non-display area; forming a scan link and a scan pad connected to the end of the scan link, by stacking a multi conductive layer, at the non-display area; and forming a scan line, connected to the scan link, crossing the data line, at the display area.

The single conductive layer is formed of a transparent conductive layer.

The multi conductive layer is formed a multi conductive layer having an aluminum.

The forming the multi conductive layer includes forming an aluminum layer on a substrate; and forming a metal layer, covering the aluminum layer, on the aluminum layer.

The metal layer prevents the aluminum layer from being contacted with oxygen.

The metal layer includes at least any one of chrome and molybdenum.

A method of fabricating an organic electro-luminescence display device, according to a embodiment of the present invention including a display area and a non-display area, comprising forming a data link, a data pad connected to the end of the data link, a scan link, and a scan pad connected to the end of the san link, by stacking an aluminum layer and a metal layer on the aluminum layer, at the non-display area; forming a data line connected to the data link, at the display area; and forming a scan line, connected to the scan link, crossing the data line, at the display area, wherein the data link includes a transparent conductive layer stacked on the metal layer.

The metal layer prevents the aluminum layer from being contacted with oxygen.

The metal layer includes at least any one of chrome and molybdenum.

A method of fabricating an organic electro-luminescence display device, according to a embodiment of the present invention including a display area and a non-display area, comprising forming a data line at the display area; forming a data link separated from the data line in a longitudinal direction of the data line, a data pad extended with a width wider than that of the data link and connect to the end of a longitudinal direction of the data link, a scan link, and a scan pad extended with a width wider than that of the scan link and connect to the end of a longitudinal direction of the scan link, by using an aluminum layer, at the non-display area; forming a sub data link to cover the data link and the data pad and to electrically connect the data line with the data link, by using a metal layer, at the non-display area; and forming a scan line, connected to the scan link, crossing the data line, at the display area.

A method of fabricating an organic electro-luminescence display device further comprising forming a sub scan link to cover the scan link and the scan pad, by using the metal layer, at the non-display area.

The metal layer includes at least any one of chrome and molybdenum.

The sub data link and the sub scan link prevent the data link, the data pad, the scan link, and the scan pad from being contacted with oxygen.

### BRIEF DESCRIPTION OF THE DRAWINGS

These and other objects of the invention will be apparent from the following detailed description of the embodiments of the present invention with reference to the accompanying drawings, in which:

FIG. 1 is a schematic plan view illustrating a related art organic electro-luminescence display device;

FIG. 2 is a schematic plan view illustrating another related art organic electro-luminescence display device;

FIG. 3 is a sectional view illustrating a data link and a scan link taken along lines I-I' and II-II' in FIG. 2;

FIG. 4 is a schematic plan view illustrating an organic electro-luminescence display device according to first to fourth embodiments of the present invention;

FIG. 5 is a plan view illustrating a portion of the organic electro-luminescence display device according to the first to the third embodiments of the present invention;

FIG. 6 is a sectional view illustrating a data link and a scan link according to the first embodiment of the present invention taken along lines III-III' and IV-IV' in FIG. 5;

FIG. 7 is a sectional view illustrating a display area and a non-display area according to the first embodiment of the present invention taken along lines V-V' and VI-VI' in FIG. 4;

FIGs. 8A to 8D are sectional views illustrating stepwise a method of fabricating the organic electro-luminescence display device according to the first embodiment of the present invention;

FIG. 9 is a sectional view illustrating a data link and a scan link according to the second embodiment of the present invention taken along lines III-III' and IV-IV' in FIG. 5;

FIG. 10 is a sectional view illustrating a display area and a non-display area according to the second embodiment of the present invention taken along lines V-V' and VI-VI' in FIG. 4;

FIGs. 11A to 11D are sectional views illustrating stepwise a method of fabricating the organic electro-luminescence display device according to the second embodiment of the present invention;

FIG. 12 is a sectional view illustrating a data link and a scan link according to the third embodiment of the present invention taken along lines III-III' and IV-IV' in FIG. 5;

FIG. 13 is a sectional view illustrating a display area and a non-display area according to the third embodiment of the present invention taken along lines V-V' and VI-VI' in FIG. 4;

FIGs. 14A to 14D are sectional views illustrating stepwise a method of fabricating the organic electro-luminescence display device according to the third embodiment of the present invention;

FIG. 15 is a plan view illustrating a portion of the organic electro-luminescence display device according to the fourth embodiment of the present invention;

FIG. 16 is a sectional view illustrating a data link and a scan link taken along lines VII-VII' and VIII-VIII' in FIG. 15;

FIG. 17 is a sectional view illustrating a display area and a non-display area according to the fourth embodiment of the present invention taken along lines V-V' and VI-VI' in FIG. 4; and

FIGs. 18A to 18E are sectional views illustrating stepwise a method of fabricating the organic electro-luminescence display device according to the fourth embodiment of the present invention.

### DETAILED DESCRIPTION OF THE PREFERRED EMBODIMENT

Reference will now be made in detail to the preferred embodiments of the present invention, examples of which are illustrated in the accompanying drawings.

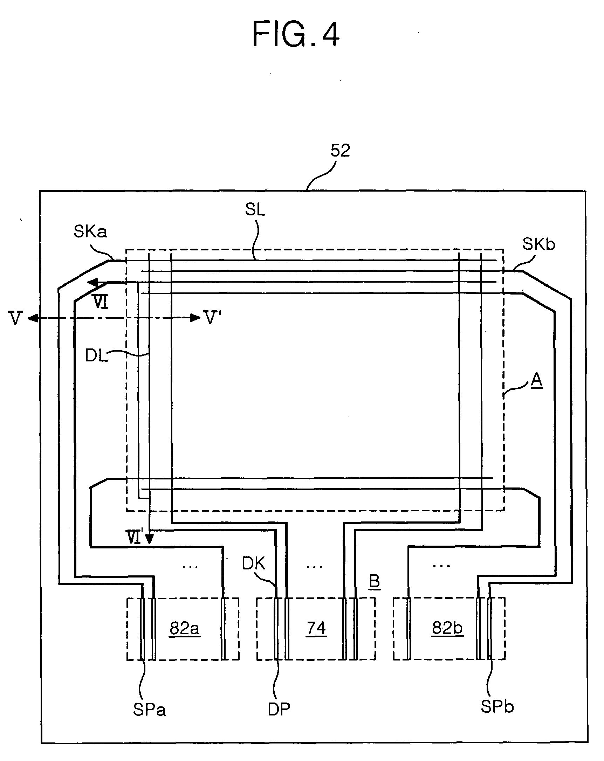

Hereinafter, the preferred embodiments of the present invention will be described in detail with reference to FIGs. 4 to 18E.

FIG. 4 is a schematic plan view illustrating an organic electro-luminescence display(EL) device according to first to fourth embodiments of the present invention.

Referring to FIG. 4, the organic EL display device according to the embodiment of the present invention includes: a data line DL and a scan line SL crossing each other; and a display area A, where an EL cell(not shown) formed at a cross of the data line DL and the scan line SL in a matrix type is located, and where a picture is realized upon organic emission.

The EL display device further includes: a data link DK extended from the data line DL of the display area A; a data pad part 74 provided with a data pad DP, having a width wider than that of the data link DK at the end part of the data link DK; a scan link SK connected to the scan line SL; and a non-display area B where first and second scan pad part 82a and 82b are located, wherein the first and the second scan pad parts 82a and 82b have first and second scan pads SPa and SPb having a width wider than that of the scan link SK at the end part of the scan link SK.

The first and the second pad parts 82a and 82b are divided into both side of the data pad part 74 to be formed at a lower side of the substrate 52 of the organic EL display device, for the purpose of integration.

The data pad part 74, and the first and the second scan pad part 82a and 82b are connected to a tape carrier package TCP (not shown) on which a data driver (not shown) generating a data signal and first and second scan drivers (not shown) generating a scan signal are mounted.

The data pad part 74 supplies the data signal, applied from the data driver to the data line DL, via each data pad DP and data link DK, to the corresponding data line DL. The first and the second scan pad parts 82a and 82b supply the scan signal, applied from the first and the second scan drivers to the scan line SL, via each scan pad SPa and SPb and scan links SKa and SKb, to the corresponding scan line SL.

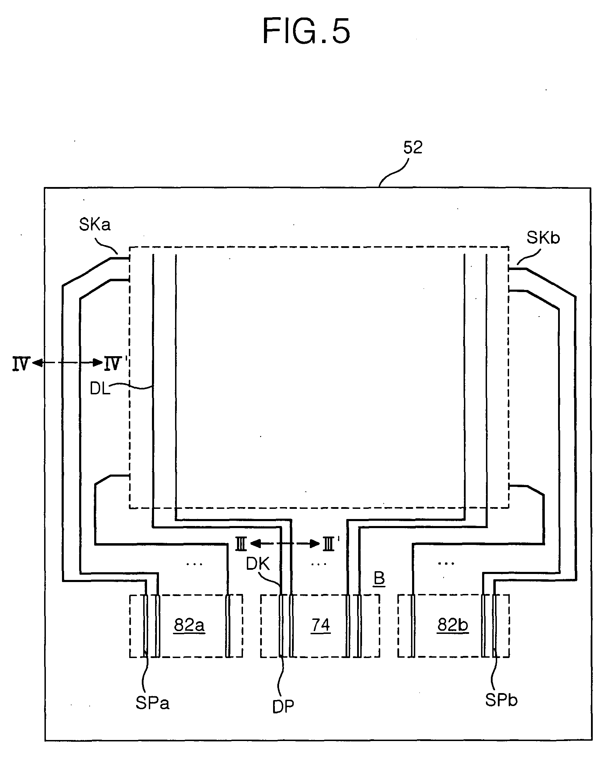

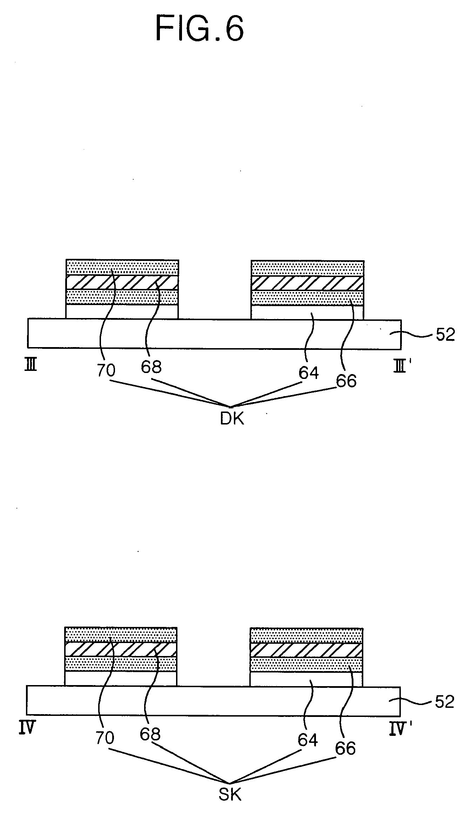

FIG. 5 is a plan view illustrating a portion of the organic electro-luminescence display device according to the first to the third embodiments of the present invention, and FIG. 6 is a sectional view illustrating a data link and a scan link according to the first embodiment of the present invention taken along lines III-III' and IV-IV' in FIG. 5.

Referring to FIGs. 5 and 6, the organic EL display device according to the first embodiment of the present invention includes a data link DK and a scan link SK at the non-display B area. Herein, the data link DK and the scan link SK respectively include a transparent conductive layer 64, a first metal layer 66, a aluminum layer 68 and a second metal layer 70, that are sequentially deposited.

A transparent conductive material such as ITO, IZO, ITZO and the like is entirely deposited on the substrate 52 and is patterned to form the transparent conductive layer 64 of the data link DK and the scan link SK by the same process as the data line DL of the display area A.

A first conductive metal material, an aluminum Al and a second conductive metal material are sequentially deposited on the substrate 52 and are patterned to form the first metal layer 66, the aluminum layer 68 and the second metal layer 70.

Accordingly, the data link DK and the scan link SK passing through the non-display area B include the aluminum Al having a low resistance to compensate the data link DK and the scan link SK including the transparent conductive material such as ITO, IZO and ITZO, having a high resistance. Thus, emission efficiency of the organic EL display device becomes improved and a deterioration of picture quality becomes reduced.

In this case, an oxidization caused by contacting the aluminum layer 68 of the data link DK and the scan link DK with the transparent conductive layer 64 is prevented by using the first metal layer 66 formed between the transparent conductive layer 64 and the aluminum layer 68. Further, an oxidization caused by exposing the aluminum layer 68 of the data link DK and the scan link SK in the air is prevented by using the second metal layer 70.

The first and the second metal layers 60 and 70 include chrome Cr or molybdenum Mo.

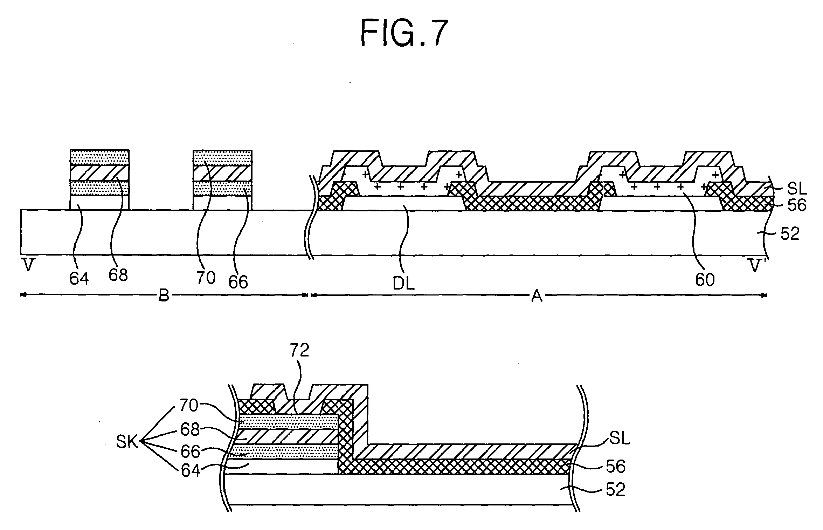

FIG. 7 is a sectional view illustrating a display area and a non-display area according to the first embodiment of the present invention taken along lines V-V' and VI-VI' in FIG. 4.

Referring to FIG. 7, the organic EL display device according to the first embodiment of the present invention includes: a data line DL separated from a predetermined distance at a display area A of the substrate 52; a data link DK, extended from the data line DL of the display area A, at the non-display area B; and a scan link SK connected to a scan link SL.

A transparent conductive layer 64, a first metal layer 66, an aluminum layer 68, and a second metal layer 70 are sequentially stacked to form the scan link SK and the data link DK.

Further, the organic EL display device includes: an insulating film 56, having an open part for each EL cell(not shown) and having a contact hole 72 to connect the scan line SL of the display area A to the scan link SK of the non-display area B, at the display area A on the substrate 52; a barrier rib 58 to separate the organic light emitting layer 60 from the scan line SL on the insulating film 56; and the scan line SL of the display area A contacted with72 the scan link SK of the non-display area B through the contact hole.

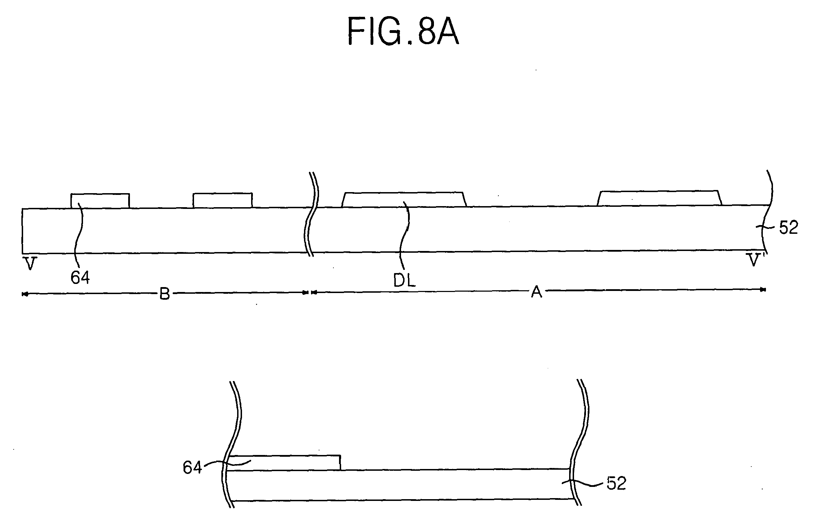

Hereinafter, a method of fabricating the organic electro-luminescence display device according to the first embodiment of the present invention will be stepwise described with reference to FIGs. 8A to 8D as follows.

Referring to FIG. 8A, transparent conductive material such as ITO, IZO, ITZO and the like is entirely deposited and is patterned at the display area A on the substrate 52 to form a data line DL separated by a predetermined distance. At the same time, a transparent conductive layer 64 of the data link DK and a transparent conductive layer 64 of a scan link SK, being connected to a scan line SL formed by a following process, are separated by a predetermined distance to be formed at a non-display area B on the substrate by the same process.

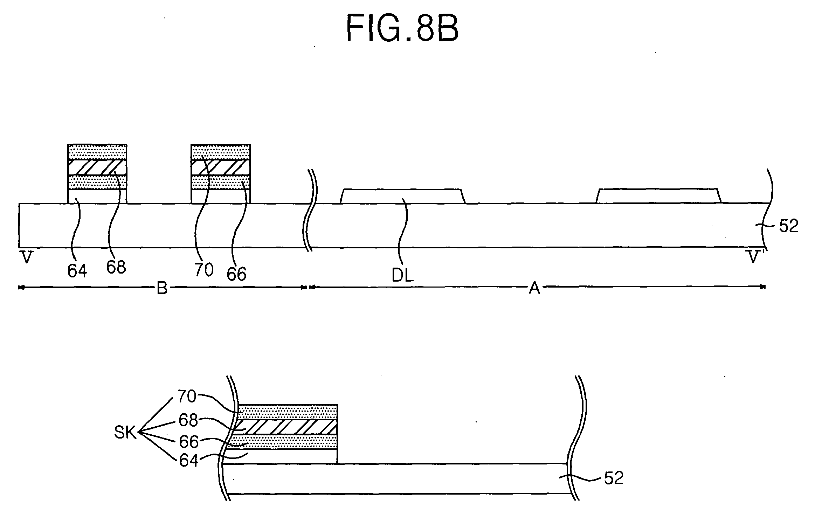

Next, as shown in FIG. 8B, a first metal material is entirely deposited on the substrate 52 having the data line DL, the transparent conductive layer 64 of the data link DK and the scan link SK, an Aluminum Al is entirely deposited on the substrate 52 on which the first metal material is entirely deposited, and a second metal material is entirely deposited on the substrate 52 on which the aluminum is entirely deposited and then is patterned to thereby form the data link DK and the scan link SK, in which the transparent conductive layer 64, the first metal layer 66, the aluminum layer 68, and the second metal layer 70 are sequentially stacked, at the non-display area B.

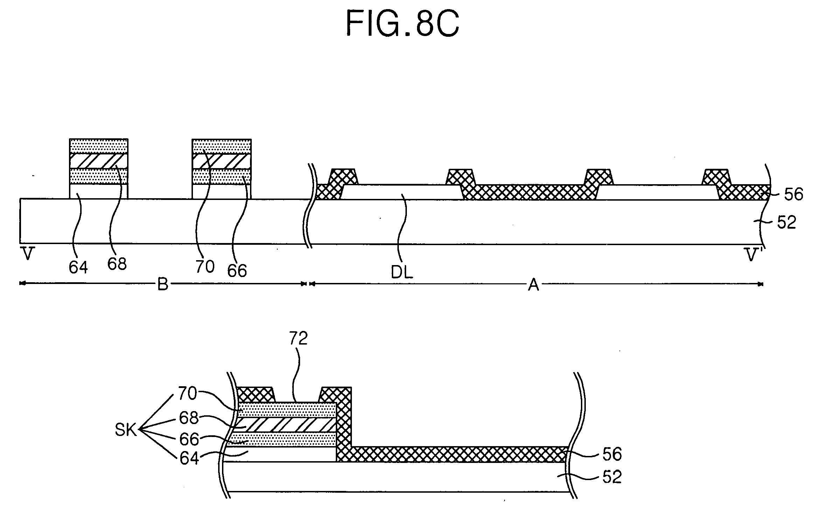

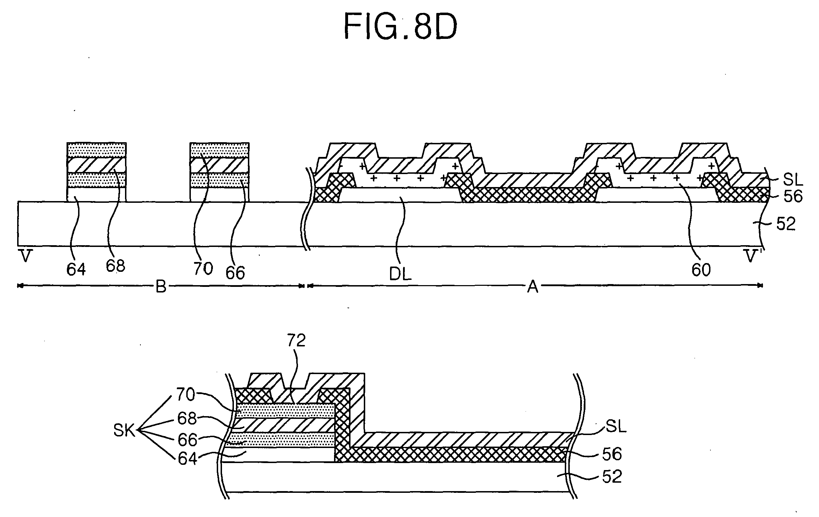

On the substrate 52 having the data line DL of the display area A, and the data link and the scan link SK of the non-display area B, as shown in FIG. 8C, an insulating material is entirely deposited and is patterned, to thereby form an insulating layer 56 that has an open part for each EL cell(not shown) and a contact hole 72 for connecting the scan line SL of the display area A, formed by a following process, to the scan link SK of the non-display area B. Subsequently, a barrier rib 58 for separating the organic light emitting layer 60 from the scan line SL is formed on the display area A having the insulating layer 56. The barrier rib 58 is formed in a direction cross the data line DL. Thereafter, on the substrate 52 having the barrier rib 58, as shown in FIG. 8D, an organic light-emitting material is deposited by using a mask to form the organic light emitting layer 60, and then an electrode material is entirely deposited to form the scan line SL. Each scan link SK of the non-display area B is connected to its correspondence scan line SL of the display area A via the contact hole 72 upon entirely depositing the electrode material for forming the scan line SL.

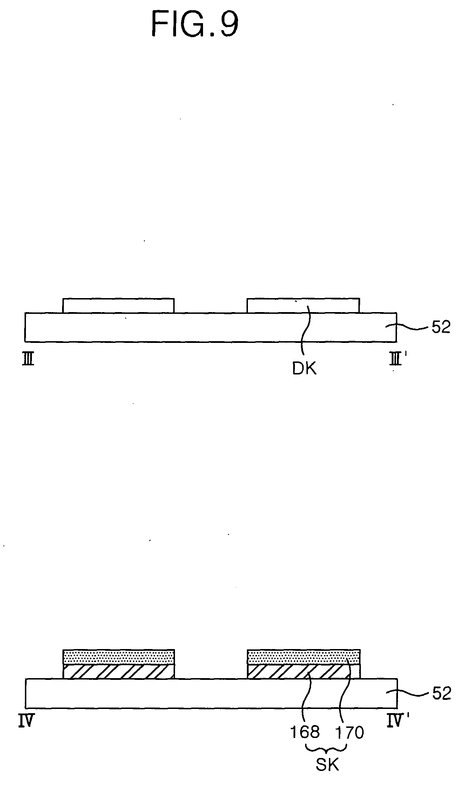

FIG. 9 is a sectional view illustrating a data link and a scan link according to the second embodiment of the present invention taken along lines III-III' and IV-IV' in FIG. 5.

Referring to FIG. 9, the organic EL display device according to the second embodiment of the present invention includes: a data link DK and a data pad DP formed of a transparent conductive material such as ITO, IZO, ITZO and the like at a non-display area B; and a scan link SK and a scan pad SP in which an aluminum layer 168 and a second metal layer 170 are sequentially deposited on the non-display area B.

A transparent conductive material such as ITO, IZO, ITZO and the like is entirely deposited on the substrate 52 and is patterned to form the data link DK and the data pad DP by the same process as the data line DL of a display area A.

An aluminum Al and a conductive metal material are sequentially deposited on the substrate 52 and are patterned to form the scan link SK and the scan pad SP.

Accordingly, since the scan link SK formed at the non-display area B is formed of an aluminum Al, a resistance of the scan link SK passing through the non-display area of a long distance as compared to the data link DK can be reduced. Thus, emission efficiency of the organic EL display device becomes improved and a deterioration of picture quality becomes reduced.

In this connection, the metal layer 170 of the scan link SK and the scan pad SP includes chrome Cr or molybdenum Mo and prevents the aluminum layer 168 of the scan link SK and the scan pad SP formed of the aluminum Al from being contacted with oxygen.

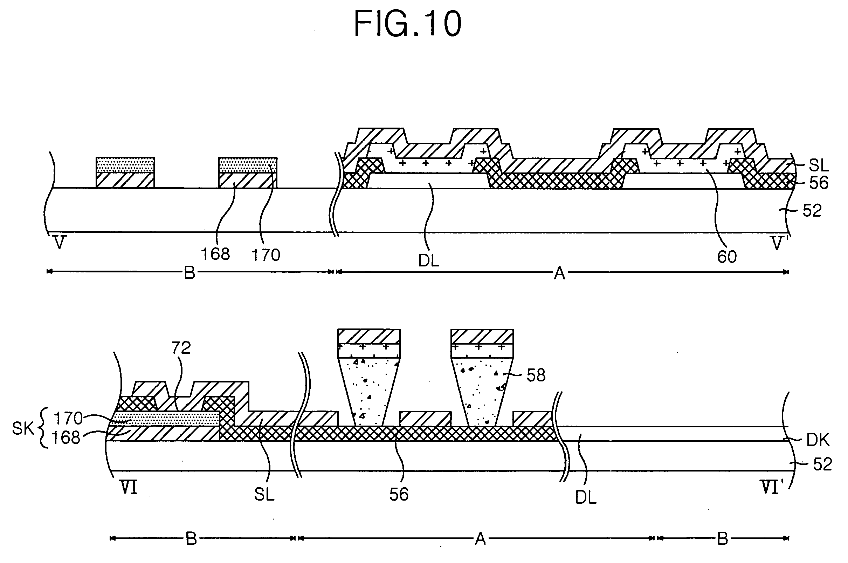

FIG. 10 is a sectional view illustrating a display area and a non-display area according to the second embodiment of the present invention taken along lines V-V' and VI-VI' in FIG. 4.

Referring to FIG. 10, the organic EL display device according to the second embodiment of the present invention includes: a data line DL separated from a predetermined distance at a display area A of the substrate 52; a data link DK, extended from the data line DL of the display area A, at the non-display area B; and a scan link SK, having an aluminum layer 168 and a metal layer 170, connected to a scan link SL.

Further, the organic EL display device includes: an insulating film 56, having an open part for each EL cell(not shown) and having a contact hole 72 to connect the scan line SL of the display area A to the scan link SK of the non-display area B, at the display area A on the substrate 52; a barrier rib 58 to separate the organic light emitting layer 60 from the scan line SL on the insulating film 56; and the scan line SL of the display area A contacted with the scan link SK of the non-display area B through the contact hole 72.

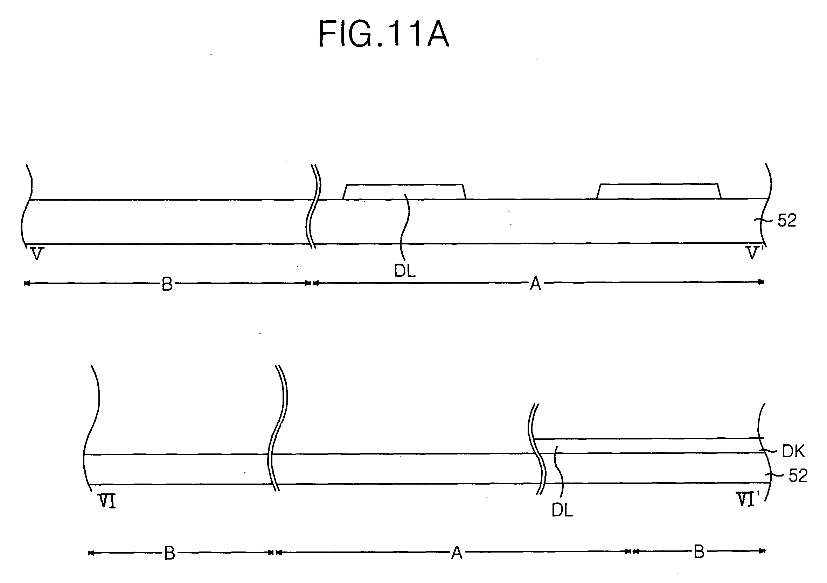

Hereinafter, a method of fabricating the organic electro-luminescence display device according to the second embodiment of the present invention will be stepwise described with reference to FIGs. 11A to 11D as follows.

Referring to FIG. 11A, transparent conductive material such as ITO, IZO, ITZO and the like is entirely deposited and is patterned on the substrate 52 to form a data line DL of a display area A and a data link DK of a non-display area B by separating by a predetermined distance.

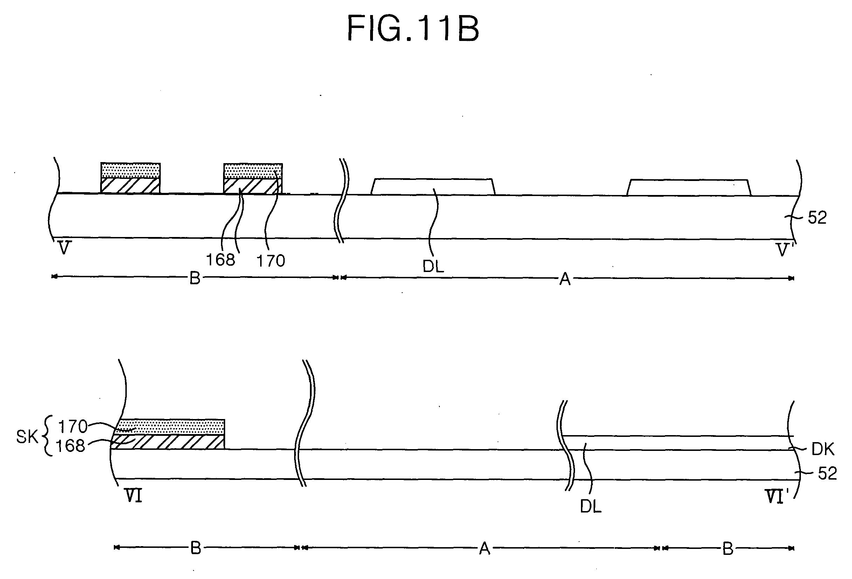

Next, as shown in FIG. 11B, Aluminum Al is entirely deposited on the substrate 52, having the data line DL of the display area A and the data link DK of the non-display area B, and then chrome Cr or molybdenum Mo is entirely deposited on the substrate 52 having the deposited aluminum Al and is patterned, to thereby form the scan link SK in which an aluminum layer 168 and a metal layer 170 are sequentially stacked at the non-display area B.

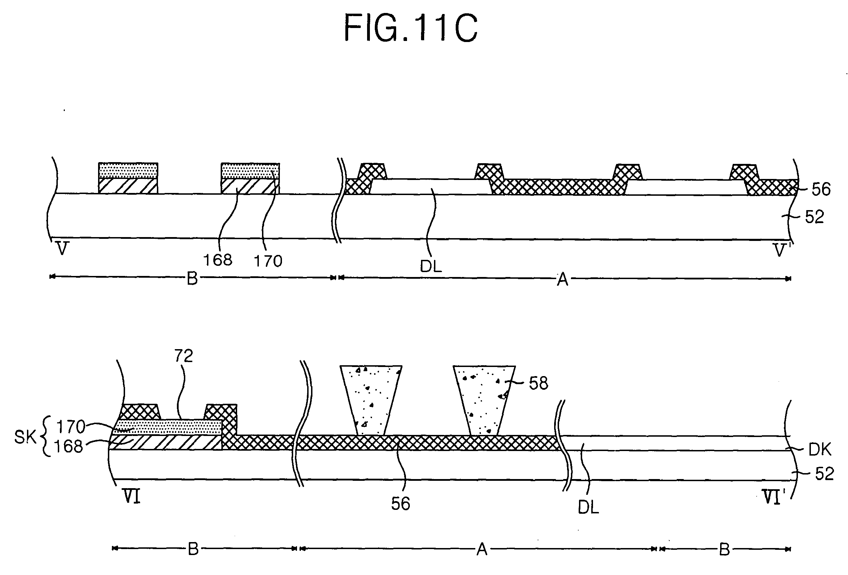

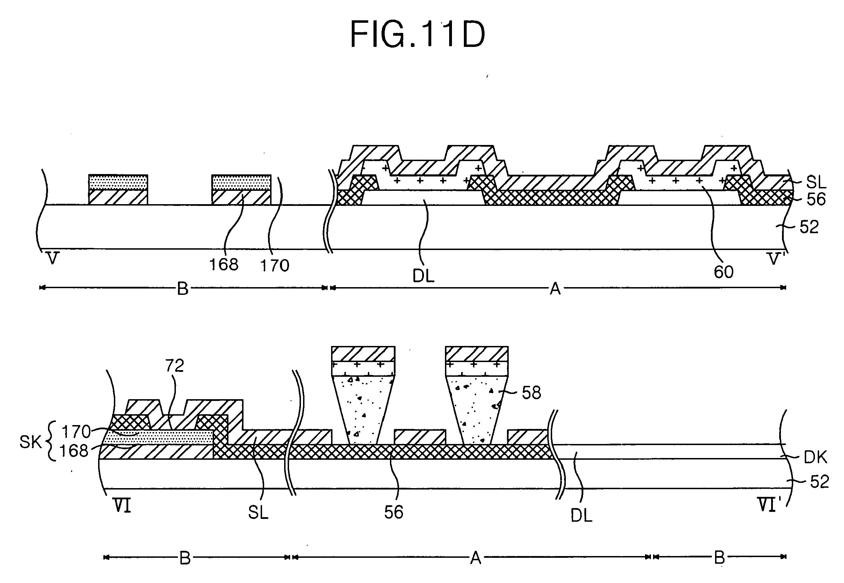

On the substrate 52 having the data line DL of the display area A and the data link DK and the scan link SK of the non-display area B, as shown in FIG. 11C, an insulating material is entirely deposited and is patterned, to thereby form an insulating film 56 that has an open part for each EL cell(not shown) and a contact hole 72 for connecting the scan line SL of the display area A, formed by a following process, to the scan link SK of the non-display area B. Subsequently, a barrier rib 58 for separating the organic light emitting layer 60 from the scan line SL is formed on the display area A having the insulating film 56. The barrier rib 58 is formed in a direction crossing the data line DL. Thereafter, on the substrate 52 having the barrier rib 58, as shown in FIG. 11D, an organic light-emitting material is deposited by using a mask to form the organic light emitting layer 60, and then an electrode material is entirely deposited to form the scan line SL. Each scan link SK of the non-display area B is connected to its correspondence scan line of the display area A via the contact hole 72 upon entirely depositing the electrode material for forming the scan line SL.

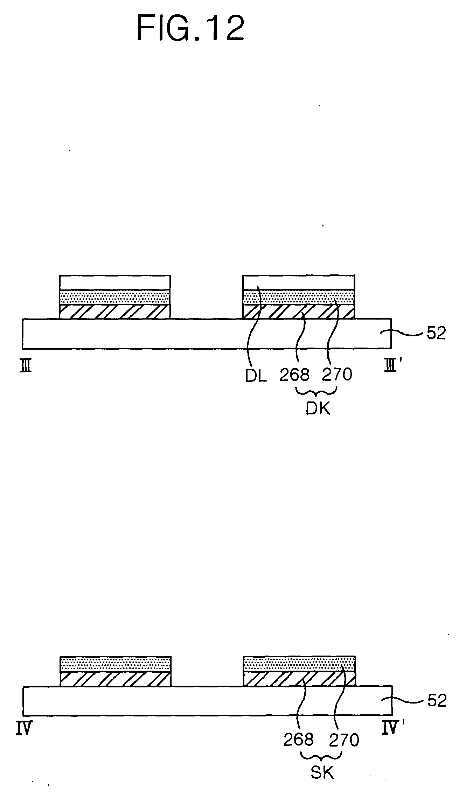

FIG. 12 is a section view illustrating a data link and a scan link according to the third embodiment of the present invention taken along lines III-III' and IV-IV' in FIG. 5

Referring to FIG. 12, the organic EL display device according to the third embodiment of the present invention includes a data link DK and a scan link SK, on which an aluminum layer 268 and a metal layer 270 are sequentially stacked.

An aluminum Al and a conductive metal material are sequentially deposited on the substrate 52 and are patterned to form the data link DK and the scan link SK.

Accordingly, the data link DK and the scan link SK passing through the non-display area B are formed by using the aluminum Al, to thereby reduce a resistance of both the data link DK and the scan link SK. Thus, emission efficiency of the organic EL display device becomes improved and a deterioration of picture quality becomes reduced.

In this connection, the metal layer 270 of the data link DK and the scan link SK includes chrome Cr or molybdenum Mo and prevents the aluminum layer 268 of the data link DK and the scan link SK from being contacted with oxygen. Further, the metal layer 270 of the data link DK formed on the aluminum layer 268 of the data link DK prevents the data line DL formed of a transparent conductive material such as ITO, IZO, ITZO and the like from being contacted with the aluminum layer 268 of the data link DK.

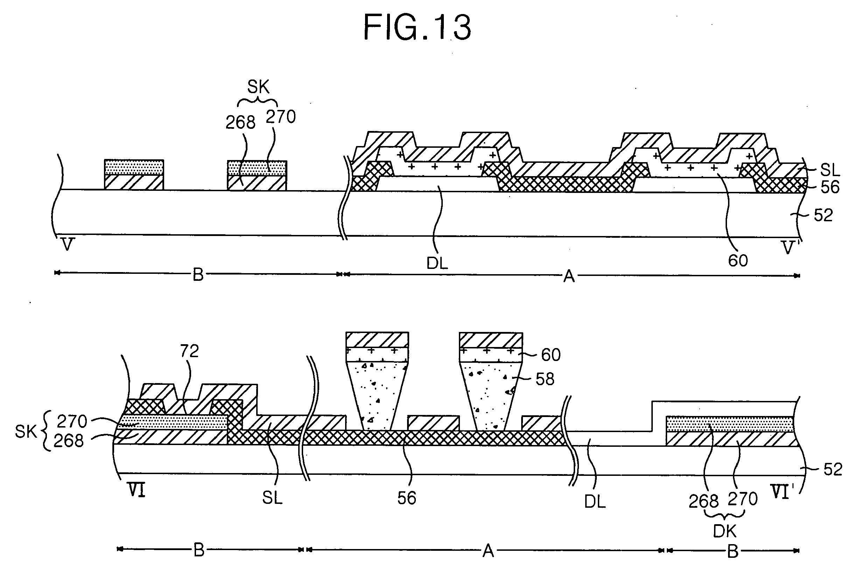

FIG. 13 is a sectional view illustrating a display area and a non-display area according to the third embodiment of the present invention taken along lines V-V' and VI-VI' in FIG. 4.

Referring to FIG. 13, the organic EL display device according to the third embodiment of the present invention includes: a data line DL separated from a predetermined distance at a display area A of the substrate 52; a data link DK, extended from the data line DL of the display area A, at the non-display area B; and a scan link SK, having an aluminum layer 268 and a metal layer 270, connected to a scan link SL.

Further, the organic EL display device includes: an insulating film 56, having an open part for each EL cell(not shown) and having a contact hole 72 to connect the scan line SL of the display area A to the scan link SK of the non-display area B, at the display area A on the substrate 52; a barrier rib 58 to separate the organic light emitting layer 60 from the scan line SL on the insulating film 56; and the scan line SL of the display area A contacted with the scan link SK of the non-display area B through the contact hole 72.

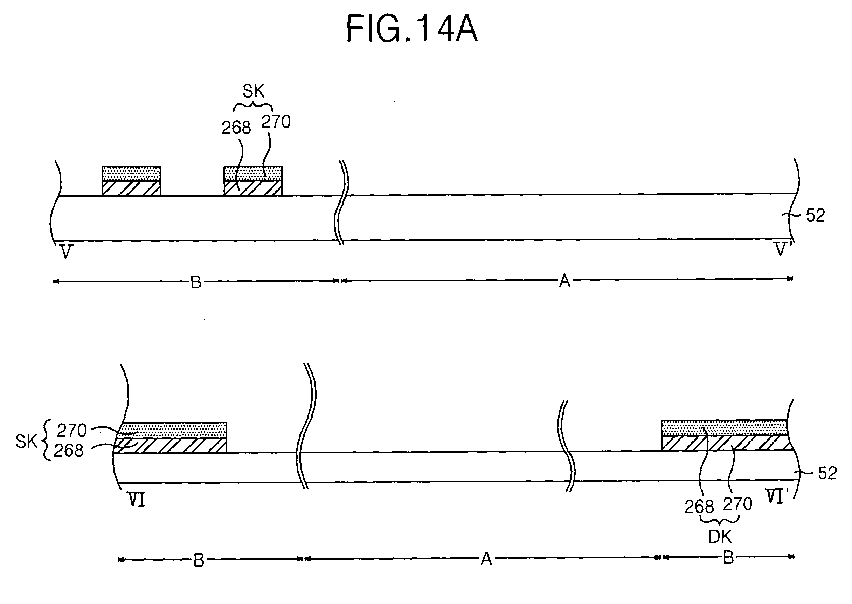

Hereinafter, a method of fabricating the organic electro-luminescence display device according to the third embodiment of the present invention will be stepwise described with reference to FIGs. 14A to 14D as follows.

Referring to FIG. 14A, aluminum Al is entirely deposited on a substrate 52 and chrome Cr or molybdenum Mo is entirely deposited on the substrate 52 having the deposited aluminum Al, and then is patterned, to thereby form a data link DK and a scan link SK, an aluminum layer 268 and a metal layer 270 are sequentially stacked, on a non-display area B.

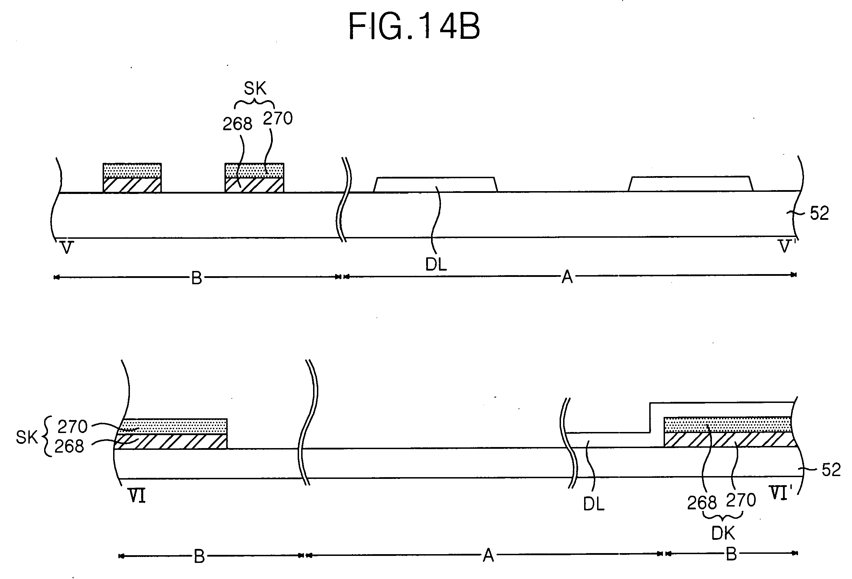

Thereafter, as shown in FIG. 14B, transparent conductive material such as ITO, IZO, ITZO and the like is entirely deposited and is patterned on the substrate 52 to form a data line DL at a display area A. In this connection, the data line DL is extended to the metal layer 270 of the data link DK to be connected to the data link DK formed at the non-display area B.

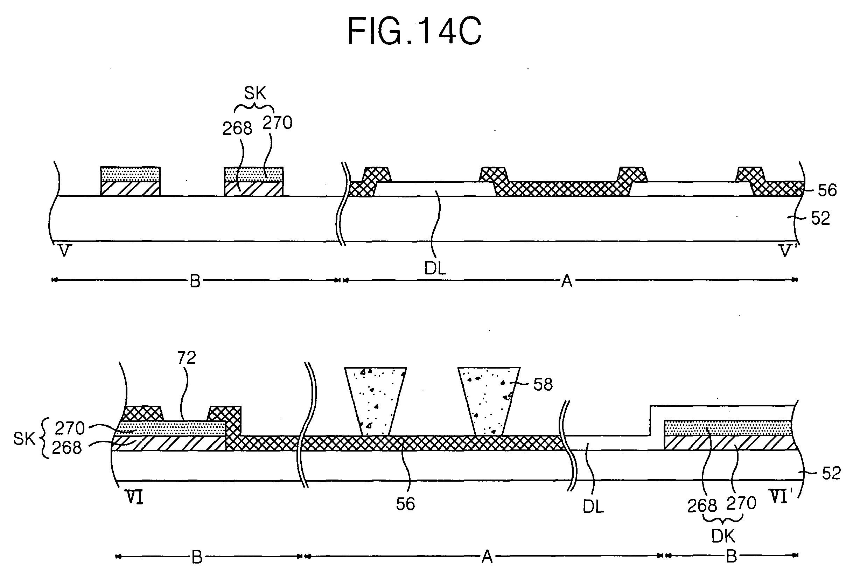

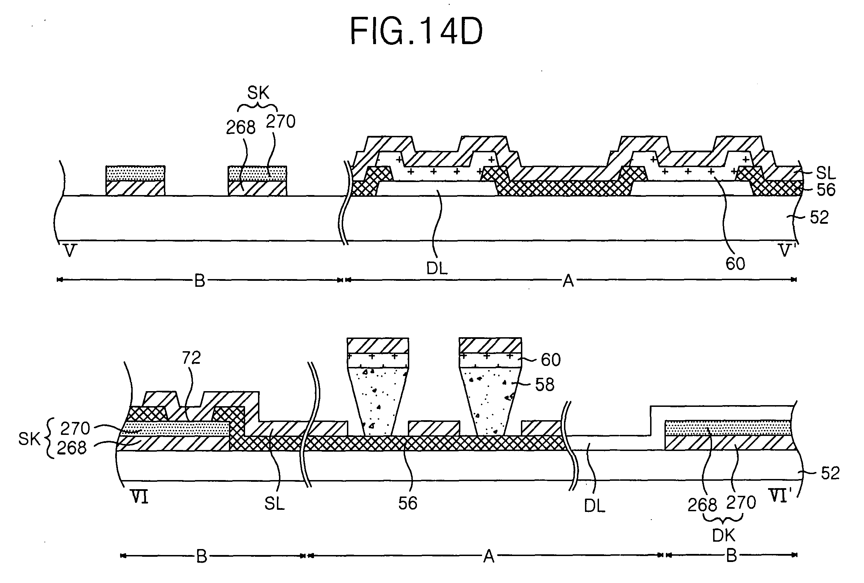

On the substrate 52 having the data line DL of the display area A and the data link and the scan link SK of the non-display area B, as shown in FIG. 14C, an insulating material is entirely deposited and is patterned, to thereby form an insulating film 56 that has an open part for each EL cell(not shown) and a contact hole 72 for connecting the scan line SL of the display area A, formed by a following process, to the scan link SK of the non-display area B. Subsequently, a barrier rib 58 for separating the organic light emitting layer 60 from the scan line SL is formed on the display area A having the insulating film 56. The barrier rib 58 is formed in a direction cross the data line DL. Thereafter, on the substrate 52 having the barrier rib 58, as shown in FIG. 14D, an organic light-emitting material is deposited by using a mask to form the organic light emitting layer 60, and then an electrode material is entirely deposited to form the scan line SL. Each scan link SK of the non-display area B is connected to its correspondence scan line SL of the display area A via the contact hole 72 upon entirely depositing the electrode material for forming the scan line SL.

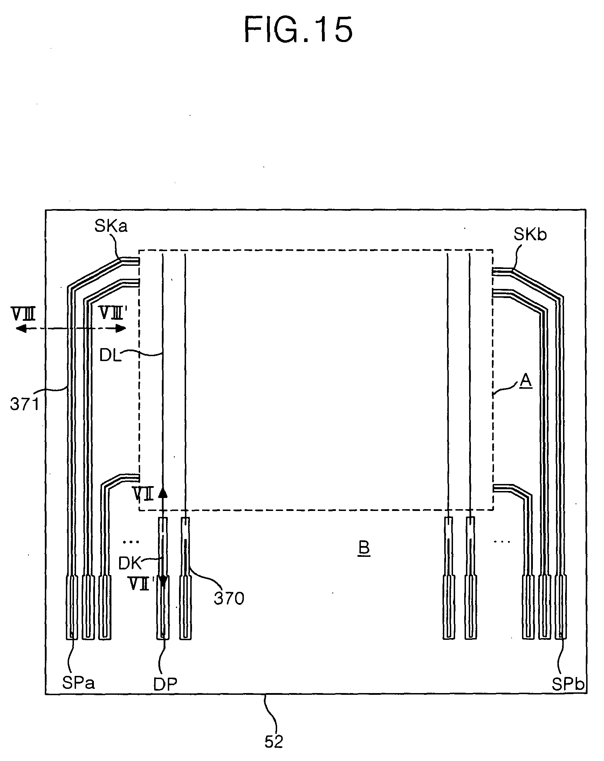

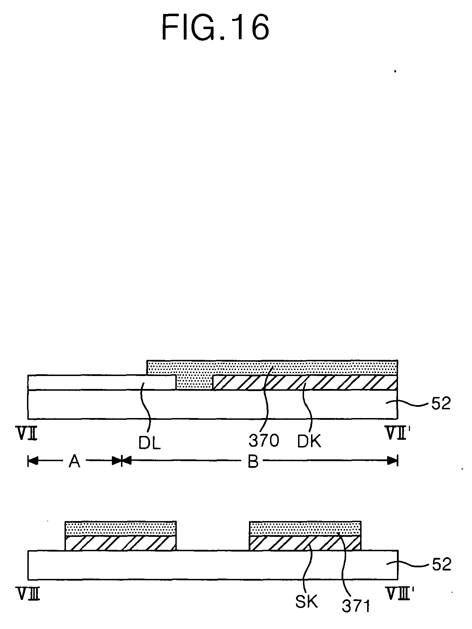

FIG. 15 is a plan view illustrating a portion of the organic electro-luminescence display device according to the fourth embodiment of the present invention, and FIG. 16 is a sectional view illustrating a data link and a scan link taken along lines VII-VII' and VIII-VIII' in FIG. 15.

Referring to FIGs. 15 and 16, the organic EL display device according to the second embodiment of the present invention includes: a data line DL formed of a transparent conductive material, at a display area A; and a data link DK and a scan link SK, which are formed of aluminum Al, at a non-display area B.

The data link DK formed of aluminum Al is formed to be not connected to the data line DL in order to prevent the data link DK from being corroded upon contacting with the data line DL. For this reason, the organic EL display device further includes a sub data link 370 for connecting the data line DL of the display area A to the data link DK of the non-display area B.

The sub data link 370 is formed to cover the data link DK and the data pad DP at the non-display area B. At this moment, a sub scan link SK covering the scan link SK and the scan pad SP at the non-display area B is further formed together.

The sub data link 370 and the sub scan link 371 are formed of chrome Cr or molybdenum Mo, and prevent the data link DK, the data pad DP, the scan link SK and scan pad SP, which are formed of aluminum Al, from being contacted with oxygen.

As mentioned above, the data link DK and the scan link SK, which are formed at the non-display area B, are formed of aluminum Al, so that it is possible to reduce a resistance of the data link DK and the scan link SK. Accordingly, emission efficiency of the organic EL display device becomes improved and a deterioration of picture quality becomes reduced.

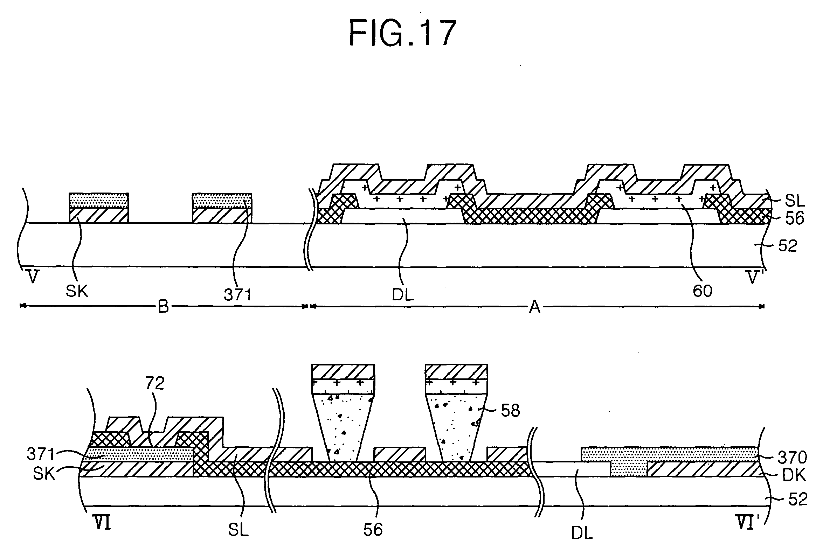

FIG. 17 is a sectional view illustrating a display area and a non-display area according to the fourth embodiment of the present invention taken along the lines V-V' and VI-VI' in FIG. 4.

Referring to FIG. 17, the organic EL display device according to the fourth embodiment of the present invention includes: a data line DL separated from a predetermined distance at a display area A of the substrate 52; and a data link DK, a data pad DP, a scan link SK, and a scan pad SP, at a non-display area B of the substrate 52.

The data link DK is formed to be not connected to the data line DL formed at the display area A.

The organic EL display device further includes a sub data link 370 and a sub scan link 371, which cover the data link DK, the data pad DP, the scan link SK and the scan pad SP. The sub data link 370 is formed to connect the data link DK to the data line DL of the display area A, which are not connected from each other.

Further, the organic EL display device includes: an insulating film 56, having an open part for each EL cell(not shown) and having a contact hole 72 to connect the scan line SL of the display area A to the scan link SK of the non-display area B, at the display area A on the substrate 52; a barrier rib 58 to separate the organic light emitting layer 60 from the scan line SL on the insulating film 56; and the scan line SL of the display area A contacted with the scan link SK of the non-display area B through the contact hole 72.

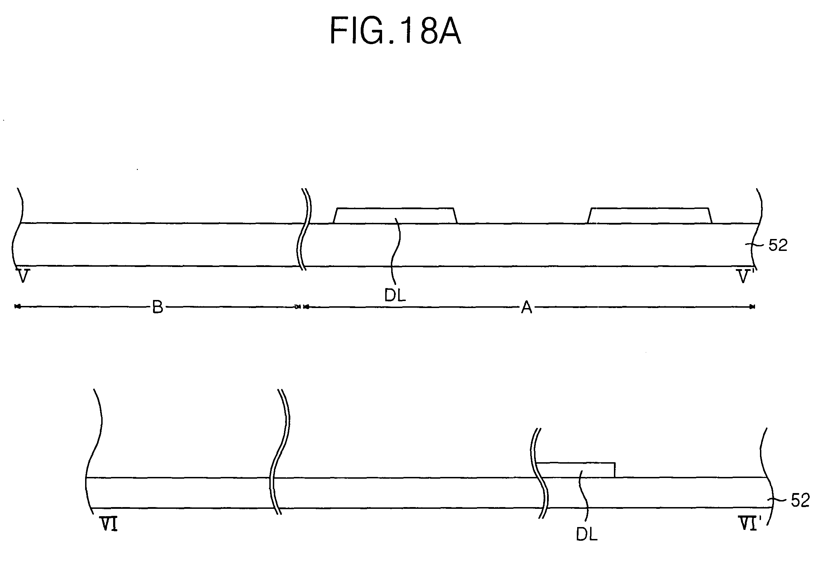

FIGs. 18A to 18E are sectional views illustrating stepwise a method of fabricating the organic EL display device according to the fourth embodiment of the present invention.

Referring to FIG. 18A, transparent conductive material such as ITO, IZO, ITZO and the like is entirely deposited and is patterned on the substrate 52 to form a data line DL separated by a predetermined distance at a display area A.

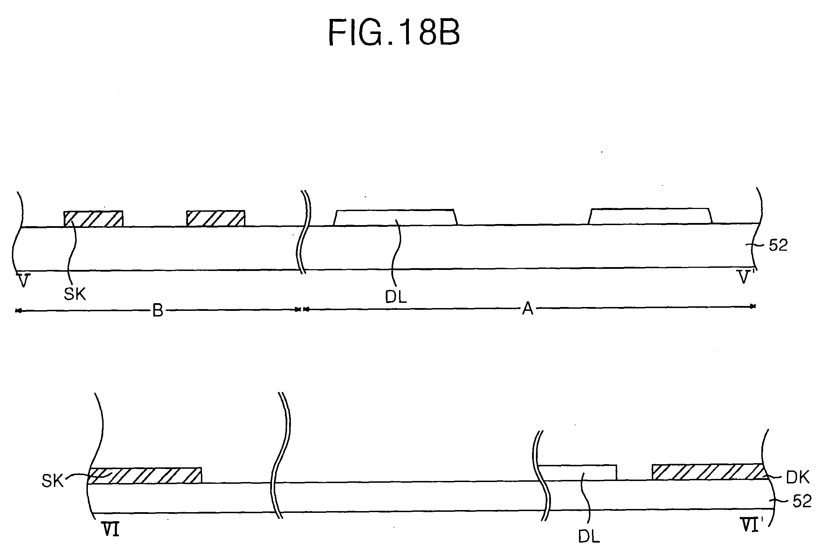

Next, as shown in FIG. 18B, aluminum Al is entirely deposited on the substrate 52 having the data line DL and then is patterned, to thereby form a data link DK, a data pad DP, a scan link SK, a scan pad SP at a non-display area B. In this connection, the data link DK is formed to be not connected to the data line DL formed at the display area A.

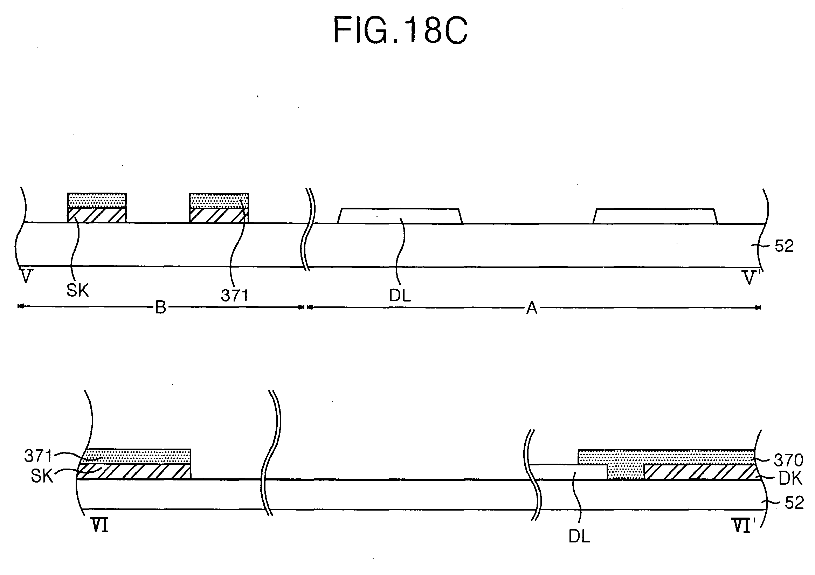

Chrome Cr or molybdenum Mo is entirely deposited on the substrate 52 having the data link DK, the data pad DP, the scan link SK and the scan pad SP and then is patterned, to thereby form a sub data link 370 covering the data link DK and the data pad DP, and a sub scan link 371 covering the scan link SK and the scan pad SP, as shown in FIG. 18C. The sub data link 370 is formed to connect the data line DL of the display area A with the data link DK of the non-display area B, in which the data line DL of the display area A is not electrically connected to the data link DK of the non-display area B.

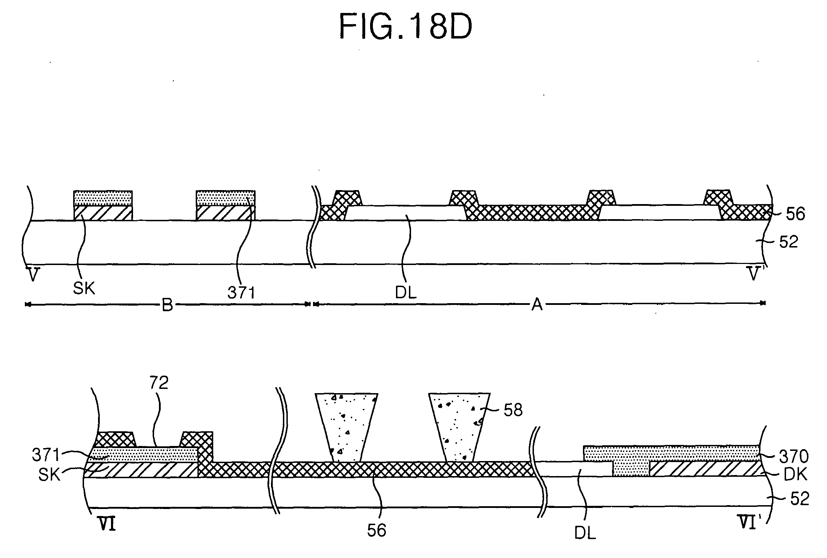

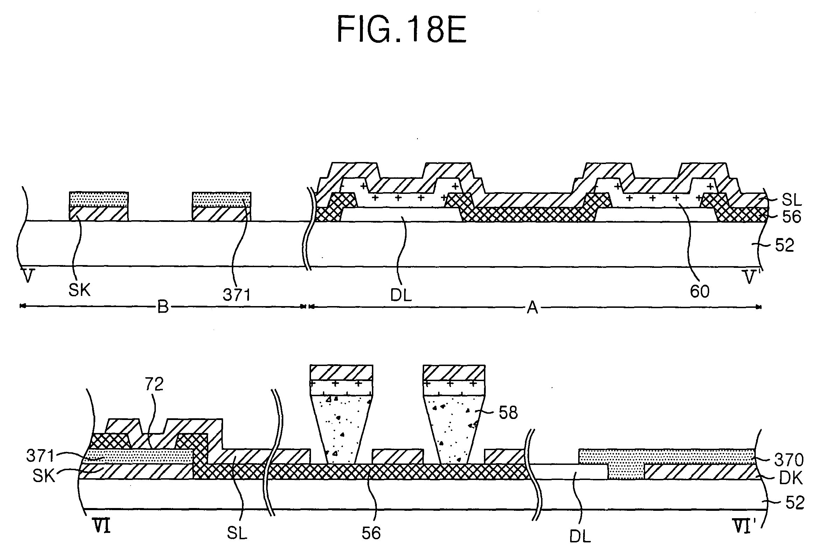

On the substrate 52 having the data line DL of the display area A and the sub data link 370 and the sub scan link 371 of the non-display area B, as shown in FIG. 18D, an insulating material is entirely deposited and is patterned, to thereby form an insulating film 56 that has an open part for each EL cell(not shown) and a contact hole 72 for connecting the scan line SL of the display area A, formed by a following process, to the scan link SK of the non-display area B. Subsequently, a barrier rib 58 for separating the organic light emitting layer 60 from the scan line SL is formed on the display area A having the insulating film 56. The barrier rib 58 is formed in a direction crossing the data line DL. Thereafter, on the substrate 52 having the barrier rib 58, as shown in FIG. 18E, an organic light-emitting material is deposited by using a mask to form the organic light emitting layer 60, and then an electrode material is entirely deposited to form the scan line SL. Each scan link SK of the non-display area B is connected to its correspondence scan line of the display area A via the contact hole 72 upon entirely depositing the electrode material for forming the scan line SL.

As described above, in the organic electro-luminescence display device and the method of fabricating the same according to the embodiments of the present invention, the data link and the scan link are formed by the metal material having a low resistance like aluminum. Accordingly, a resistance of the data link and the scan link, formed at the non-display area, becomes reduced. Thus, it is possible to improve emission efficiency of the organic EL display device and reduce a deterioration of picture quality.

Although the present invention has been explained by the embodiments shown in the drawings described above, it should be understood to the ordinary skilled person in the art that the invention is not limited to the embodiments, but rather that various changes or modifications thereof are possible without departing from the spirit of the invention. Accordingly, the scope of the invention shall be determined only by the appended claims and their equivalents.

## Claims

1. An organic electro-luminescence display device, including a display area and a non-display area, comprising:
a data line and a scan line, which are formed in a direction crossing each other, at the display area;
a data link, extended from the data line, and a scan link, connected to the scan line, at the non-display area; and
a data pad extended with a width wider than that of the data link and connected to the end of the data link formed at the non-display area, and a scan pad extended with a width wider than that of the scan link and connected to the end of the scan link formed at the non-display area,
wherein at least any one of the data link, the data pad, the scan link, and the scan pad are formed in a multi conductive layer.

2. The organic electro-luminescence display device according to claim 1, wherein the data link, the data pad, the scan link, and the scan pad are formed in a multi conductive layer having a transparent conductive layer.

3. The organic electro-luminescence display device according to claim 2, wherein the multi conductive layer includes:
the transparent conductive layer formed on a substrate;
an aluminum layer formed on the transparent conductive layer;
a first metal layer formed between the transparent conductive layer and the aluminum layer; and
a second metal layer formed on the aluminum layer.

4. The organic electro-luminescence display device according to claim 3, wherein the first metal layer prevents corrosion caused when the aluminum layer is connected to the transparent conductive layer.

5. The organic electro-luminescence display device according to claim 3, wherein the second metal layer prevents corrosion caused when the aluminum is exposed in the air.

6. The organic electro-luminescence display device according to claim 3, wherein each of the first and the second metal layers includes at least any one of chrome and molybdenum.

7. The organic electro-luminescence display device according to claim 1, wherein the data link and the data pad are formed in only a single conductive layer, and the scan link and the scan pad are formed in a multi conductive layer.

8. The organic electro-luminescence display device according to claim 7, wherein the single conductive layer is a transparent conductive layer.

9. The organic electro-luminescence display device according to claim 7, wherein the multi conductive layer includes aluminum.

10. The organic electro-luminescence display device according to claim 9, wherein the multi conductive layer includes:
an aluminum layer on a substrate; and a metal layer, covering the aluminum layer, on the aluminum layer.

11. The organic electro-luminescence display device according to claim 9, wherein the metal layer prevents the aluminum layer from being contacted with oxygen.

12. The organic electro-luminescence display device according to claim 11, wherein the metal layer includes at least any one of chrome and molybdenum.

13. The organic electro-luminescence display device according to claim 1, wherein each of the data link, the data pad, the scan link, and the scan pad includes an aluminum layer and a metal layer stacked on the aluminum layer, and wherein the data link includes a transparent conductive layer stacked on the metal layer.

14. The organic electro-luminescence display device according to claim 13, wherein the metal layer prevents the aluminum layer from being contacted with oxygen.

15. The organic electro-luminescence display device according to claim 14, wherein the metal layer includes at least any one of chrome and molybdenum.

16. An organic electro-luminescence display device, including a display area and a non-display area, comprising:
a data line formed of a transparent conductive layer at the display area;
a scan line crossing the data line with an organic light-emitting layer therebetween, at the display area;
a data link formed of an aluminum layer at the non-display area to separate from the data line in a longitudinal direction of the data line and a data pad extended with a width wider than that of the data link and connected to the end of a longitudinal direction of the data link;
a scan link formed of an aluminum layer at the non-display area to connect to the scan line and a scan pad extended with a width wider than that of the scan link and connected to the end of a longitudinal direction of the scan link; and
a sub data link formed of a metal layer at the non-display area to cover the data link and the data pad and to electrically connect the data line with the data link.

17. The organic electro-luminescence display device according to claim 16, wherein further comprising a sub scan link formed of the metal layer at the non-display area to cover the scan link and the scan pad.

18. The organic electro-luminescence display device according to claim 16, wherein the scan link, the scan pad, the data link and the data pad are formed same materials.

19. The organic electro-luminescence display device according to claim 17, wherein the sub scan link and the sub data link are formed same materials.

20. The organic electro-luminescence display device according to claim 16, wherein the metal layer includes at least any one of chrome and molybdenum.

21. The organic electro-luminescence display device according to claim 17, wherein the sub data link and the sub scan link prevent the data link, the data pad, the scan link, and the scan pad from being contacted with oxygen.

22. A method of fabricating an organic electro-luminescence display device, including a display area and a non-display area, comprising:
forming a data line at the display area, and a transparent conductive layer of: a data link extended from the data line; a data pad extended with a width wider than that of the data link and connected to the end of a longitudinal direction of the data link at the non-display area; a scan link; and a scan pad extended with a width wider than that of the scan link and connected to the end of a longitudinal direction of the scan link formed at the non-display area;
forming a multi conductive layer on the transparent conductive layer of the data link, the data pad, the scan link, and the scan pad; and
forming a scan line, connected to the scan link and crossed with the data line, at the display area.

23. The method according to claim 22, wherein the forming the multi conductive layer includes:
forming a first metal layer on the transparent conductive pattern;
forming an aluminum layer on the first metal layer; and
forming a second metal layer on the aluminum layer.

24. The method according to claim 23, wherein the first metal layer prevents corrosion caused when the aluminum layer is contacted with the transparent conductive layer.

25. The method according to claim 23, wherein the second metal layer prevents corrosion caused when the aluminum layer is exposed in the air.

26. The method according to claim 23, wherein the first and the second metal layer include at least any one of chrome and molybdenum.

27. A method of fabricating an organic electro-luminescence display device, including a display area and a non-display area, comprising:
forming a data line at the display area, and a data link, connected to the data line, having a single conductive layer, and a data pad connected to the end of the data link, at the non-display area;
forming a scan link and a scan pad connected to the end of the scan link, by stacking a multi conductive layer, at the non-display area; and
forming a scan line, connected to the scan link, crossing the data line, at the display area.

28. The method according to claim 27, wherein the single conductive layer is formed of a transparent conductive layer.

29. The method according to claim 27, wherein the multi conductive layer is formed a multi conductive layer having an aluminum.

30. The method according to claim 27, wherein the forming the multi conductive layer includes:
forming an aluminum layer on a substrate; and
forming a metal layer, covering the aluminum layer, on the aluminum layer.

31. The method according to claim 30, wherein the metal layer prevents the aluminum layer from being contacted with oxygen.

32. The method according to claim 31, wherein the metal layer includes at least any one of chrome and molybdenum.

33. A method of fabricating an organic electro-luminescence display device, including a display area and a non-display area, comprising:
forming a data link, a data pad connected to the end of the data link, a scan link, and a scan pad connected to the end of the san link, by stacking an aluminum layer and a metal layer on the aluminum layer, at the non-display area;
forming a data line connected to the data link, at the display area; and
forming a scan line, connected to the scan link, crossing the data line, at the display area,
wherein the data link includes a transparent conductive layer stacked on the metal layer.

34. The method according to claim 33, wherein the metal layer prevents the aluminum layer from being contacted with oxygen.

35. The method according to claim 34, wherein the metal layer includes at least any one of chrome and molybdenum.

36. A method of fabricating an organic electro-luminescence display device, including a display area and a non-display area, comprising:
forming a data line at the display area;
forming a data link separated from the data line in a longitudinal direction of the data line, a data pad extended with a width wider than that of the data link and connect to the end of a longitudinal direction of the data link, a scan link, and a scan pad extended with a width wider than that of the scan link and connect to the end of a longitudinal direction of the scan link, by using an aluminum layer, at the non-display area;
forming a sub data link to cover the data link and the data pad and to electrically connect the data line with the data link, by using a metal layer, at the non-display area; and
forming a scan line, connected to the scan link, crossing the data line, at the display area.

37. The method according to claim 36, further comprising forming a sub scan link to cover the scan link and the scan pad, by using the metal layer, at the non-display area.

38. The method according to claim 36, wherein the metal layer includes at least any one of chrome and molybdenum.

39. The method according to claim 36, wherein the sub data link and the sub scan link prevent the data link, the data pad, the scan link, and the scan pad from being contacted with oxygen.
